# EUROPEAN PATENT APPLICATION

(11) **EP 4 564 019 A1**
(43) Date of publication of application: **04.06.2025**
(21) Application number: 23213577.2
(22) Date of filing: 01.12.2023
(51) Int. Cl.: G01R 25/02, G01R 27/04

(54) **ACTIVE DIRECTIONAL STRUCTURE FOR A TEST AND/OR MEASUREMENT SYSTEM**

(71) Applicant: Rohde & Schwarz GmbH & Co. KG, 81671 München (DE)
(72) Inventor: Gebel, David, 80689 Munich (DE); Landolt, Oliver, Dr., 82024 Taufkirchen (DE); Rabenstein, Thomas, 95490 Mistelgau (DE)
(74) Representative: Rupp, Christian

(57) **Abstract**

The present disclosure relates to an active directional structure (10) for a test and/or measurement system (60), comprising: a generator port (P1) configured to receive a generator signal; a DUT port (P2) arranged for directly or indirectly connecting a DUT; a measurement port (P3) configured to output a measurement signal; and a reference port (P4) configured to output a reference signal. The active directional structure (10) further comprises: a first converter (11) which is configured to generate a test signal and the reference signal based on the generator signal; and a second converter (12) which is configured to: generate the measurement signal based on the test signal, a reflected signal from the DUT and the reference signal; wherein the first converter (11) and/or the second converter (12) comprise a respective transistor circuit.

## Description

### TECHNICAL FIELD

The present disclosure relates to an active directional structure for a test and/or measurement system, such as a vector network analyzer. The present disclosure further relates to a test and/or measurement system comprising such an active directional structure.

### BACKGROUND

A vector network analyzer (VNA) is a type of measurement instrument which can be used to measure network parameters of an electrical network or of a device-under-test (DUT). Such measurements should often be performed over a wide frequency range. Furthermore, to carry out such measurements, the VNA typically requires internal elements for separating and coupling out different forward and return signals from internal signal paths.

In conventional VNAs, this is often realized by a wideband system of passive directional elements (e.g., bridges) within the VNA. While this approach allows for a wideband coupling, the passive elements inherently suffer from high noise and low isolation (e.g., of a generated signal to a reflected signal) due to the architecture of the bridge.

As an alternative, a narrowband system of passive directional elements (e.g., couplers) can be used. However, this approach often suffers from the passive bandwidth limitations of the passive directional elements.

### SUMMARY

Thus, it is an objective to provide an active directional structure for a test and/or measurement system, such as a VNA, which avoids the above-mentioned disadvantages.

The objective is achieved by the solution provided in the enclosed independent claims. Advantageous implementations of the present disclosure are further defined in the dependent claims.

According to a first aspect, the present disclosure relates to an active directional structure for a test and/or measurement system. The active directional structure comprises: a generator port configured to receive a generator signal; a DUT port arranged for directly or indirectly connecting a device-under-test (DUT); a measurement port configured to output a measurement signal; and a reference port configured to output a reference signal. The active directional structure further comprises a first converter and a second converter.

The first converter is configured to: receive the generator signal at an input which is connected to the generator port, generate a test signal based on the generator signal and output the test signal at a first output which is connected to the DUT port, and generate the reference signal based on the generator signal and output the reference signal at a second output which is connected to the reference port. The second converter is configured to: receive the test signal and a reflected signal from the DUT at a first input, receive the reference signal at a second input, and generate the measurement signal based on the test signal, the reflected signal and the reference signal, and output the measurement signal at an output which is connected to the measurement port. The first converter and/or the second converter comprise a respective transistor circuit.

This achieves the advantage that an active directional structure is provided which can operate in an ultra-wideband range, in particular due to the use of fast switching transistors in at least one of its converters. At the same time, the active directional structure provides lower noise and higher port isolations than structures with passive / resistive bridges.

The test and/or measurement system can be a measurement instrument, such as a vector network analyzer (VNA). The active directional structure can be an internal component of the VNA for combining, separating and/or forwarding various RF signals (e.g., for measuring network parameters of a DUT connected to the DUT port).

For example, the DUT can be directly connected to the DUT port However, the DUT can also be connected to a further port on the housing of the test and/or measurement system (e.g., a VNA port), wherein the DUT port of the active directional structure is connected to said port via a signal line.

The generator signal, the reference signal and the test signal can be respective RF signals (e.g., in a frequency range between DC an mmWave).

The generator signal can be a continuous wave (CW) signal which is generated by a signal generator connected to the generator port.

The test and/or the reference signal can be amplified versions of the generator signal. The test signal and the reference signal can be related to each other. For instance, the reference signal can be identical to the test signal or can be an inverted version of the test signal (e.g., both signals are equal in amplitude, but of opposite polarity), depending on the configuration of the first converter.

For instance, only one of the first and second converter comprises a transistor structure, while the other converter comprises only passives elements, such as resistors. Alternatively, both the first and the second converter comprises a respective transistor structure.

The first and second converter can be respective converter structures or converter units.

In an embodiment, the first converter is a power splitter.

The power splitter can be configured to split a signal at a single-ended input into two output signals with identical phase and polarity. Furthermore, the signal levels of both output signals can be identical. In case the signal levels of both output signals are different, this difference is known.

For example, the reference signal and test signal which are output by the power splitter can correspond to the generator signal which is received by the power splitter or can be amplified versions of the generator signal. For example, the reference signal and test signal can have the same frequency, amplitude and sign (i.e., same polarity).

In an embodiment, the second converter is configured to calculate a difference between the combined test signal and reflected signal received at the first input and the reference signal received at the second input, and to output the measurement signal based on said difference.

Hereby, combined signal means a sum or a superposition of the two signals.

The measurement signal may correspond to the difference between the signals received at the first and the second input of the second converter. This difference can correspond to the reflected signal from the DUT.

In an embodiment, the first converter is a single-ended to differential converter.

For instance, the reference signal and the test signal can correspond to the generator signal or can be amplified versions of the generator signal, but can have opposite signs. For example, the reference and test signal have the same frequency and amplitude, but opposite signs (e.g., they are signals with opposite polarity).

In an embodiment, the second converter is configured to calculate a sum of the combined test signal and the reflected signal received at the first input and the reference signal received at the second input, and to output the measurement signal based on said sum.

The measurement signal may correspond to the sum of the signals received at the first and the second input of the second converter. Due to the different polarities of the reference and test signal, this sum can correspond to the reflected signal from the DUT.

In an embodiment, the active directional structure further comprises: a first mixing device which is connected between the output of the second converter and the measurement port. This achieves the advantage that the measurement signal can be mixed down into the base band for further processing.

In an embodiment, the active directional structure further comprises: a second mixing device which is connected between the second output of the first converter and the reference port. This achieves the advantage that the reference signal can be mixed down into the base band for further processing.

The first mixing device and/or the second mixing device comprises at least one mixer connected to a local oscillator.

In an embodiment, the active directional structure further comprises: a first attenuator unit which is connected between the first output of the first converter and the DUT port; and/or a second attenuator unit which is connected between the second output of the first converter and the reference port; and/or a third attenuator unit which is connected between the output of the second converter and the measurement port.

Thereby an attenuator unit can be arranged before a respective mixing device.

The attenuator units and/or mixing devices can be arranged within the active directional structure, e.g. before the DUT port, measurement port and reference port, respectively.

In an embodiment, the active directional structure further comprises: a fourth attenuator unit which is connected directly in front of the first input of the second converter; and/or a fifth attenuator unit which is connected directly in front of the second input of the second converter.

In an embodiment, the active directional structure further comprises: an amplifier unit which is connected between the generator port and the input of the first converter. This achieves the advantage that the generator signal can be preamplified to a suitable signal level.

In an embodiment, the active directional structure is a part of a chip or a die. The chip can be a monolithic chip which can be an internal component of the test and/or measurement system, e.g. it can be arranged on a circuit board of a VNA.

The chip can be based on silicon germanium technology. However, other technologies are also possible.

For instance, the chip can comprise the mixing devices and/or the attenuator units.

According to a second aspect, the present disclosure relates to a test and/or measurement system, comprising at least one active directional structure according to the first aspect of the present disclosure; a signal generator configured to generate the generator signal, wherein an output of the signal generator is connected to the generator port of the active directional structure.

In an embodiment, the test and/or measurement system is a vector network analyzer (VNA).

In an embodiment, the test and/or measurement system further comprises: a first analog-to-digital converter unit (ADC unit) which is connected to the measurement port.

In an embodiment, the test and/or measurement system further comprises: a second analog-to-digital converter unit (ADC unit) which is connected to the reference port.

By means of the ADC units, the measurement signal and the reference signal can be digitalized for further processing by the VNA, e.g. for performing an S-parameter characterization of a connected DUT based on these signals.

### BRIEF DESCRIPTION OF THE DRAWINGS

The above described aspects and implementations are explained in the following description of embodiments with respect to the enclosed drawings:
- Fig. 1: shows a schematic diagram of an active directional structure according to an embodiment;
- Fig. 2: shows a schematic diagram of an active directional structure according to an embodiment;
- Fig. 2A: shows a schematic diagram of an active directional structure according to an embodiment;
- Fig. 3: shows a schematic diagram of an active directional structure according to an embodiment;
- Fig. 4: shows a schematic diagram of an active directional structure according to an embodiment;
- Fig. 5: shows a schematic diagram of an active directional structure according to an embodiment;
- Fig. 6: shows a schematic diagram of a test and/or measurement system according to an embodiment; and
- Fig. 7: shows an implementation of an active directional structure according to an embodiment.

### DETAILED DESCRIPTION OF EMBODIMENT

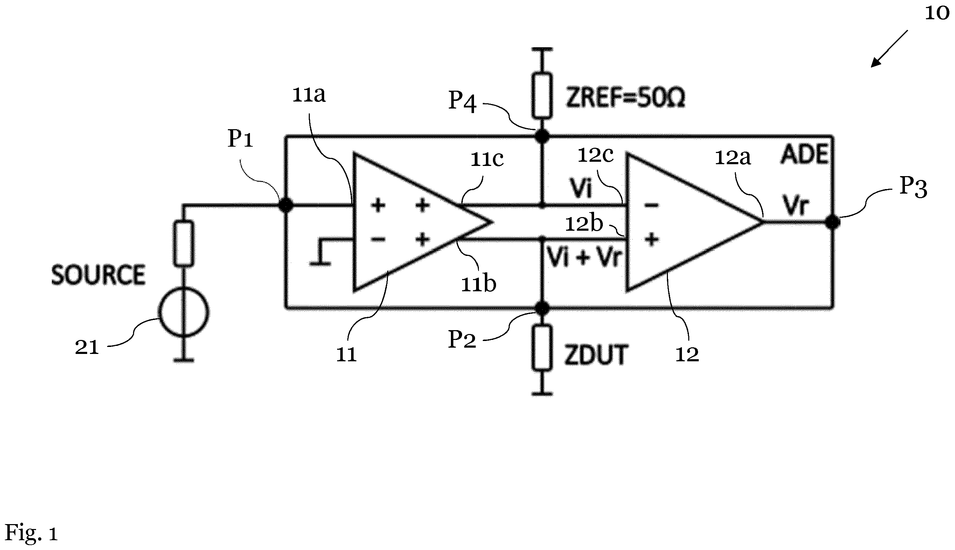

Fig. 1 shows a schematic diagram of an active directional structure 10 for use in a test and/or measurement system according to an embodiment.

The active directional structure 10 comprises: a generator port P1 configured to receive a generator signal; a DUT port P2 arranged for directly or indirectly connecting a device-under-test (DUT); a measurement port P3 configured to output a measurement signal; and a reference port P4 configured to output a reference signal.

The active directional structure 10 comprises a first converter 11 which is configured to: receive the generator signal at an input 11a which is connected to the generator port P1, generate a test signal based on the generator signal, output the test signal at a first output 11b which is connected to the DUT port P2, generate the reference signal based on the generator signal, and output the reference signal at a second output 11c which is connected to the reference port P4. The active directional structure 10 further comprises a second converter 12 which is configured to: receive the test signal and a reflected signal from the DUT at a first input 12b, receive the reference signal at a second input 12c, generate the measurement signal based on the test signal, the reflected signal and the reference signal, and output the measurement signal at an output 12a which is connected to the measurement port P3.

The first converter 11 and/or the second converter 12 of the active directional structure 10 comprise a respective transistor circuit.

Hereby, a connection between two ports refers to a connection suitable for forwarding RF signals from one port to the other port (e.g., a connection via a signal routing line).

For instance, the first converter 11 is an active element and the second converter 12 is a passive element, or vice versa. Alternatively, both the first converter 11 and the second converter 12 are active elements which comprise a respective transistor circuit.

A transistor circuit can be an electrical circuit comprising one or more transistors (e.g., a transistor based active circuit).

Due to the use of such active transistor based circuits in at least one of the converters 11, 12, the active directional structure 10 can provide lower noise and higher port isolations than comparable measurement systems which use passive/resistive bridges. At the same time, the active directional structure 10 can operate at ultra-wide bandwidths from DC to mmWave.

The active directional structure 10 can be an internal component of the test and/or measurement system, such as a vector network analyzer (VNA).

The generator port P1 can be connected to a signal generator 21 which is configured to generate the generator signal, e.g. in form of a CW signal.

A DUT can be directly or indirectly connected to the DUT port P2. In Fig. 1, the DUT impedance ZDUT is shown. The DUT can be an RF device or element, such as a cable, a filter or an attenuator.

The DUT port P2 can be arranged on a housing of the test and/or measurement system or can be a connected to a port on the housing of the test and/or measurement system.

The respective inputs 11a, 12b, 12c and outputs 11b, 11c, 12a of the first and second converter 11, 12 can comprise any means, e.g. ports, connectors or nodes, for receiving and/or forwarding RF signals.

The first output 11b of the first converter 11, the DUT port P2 and the first input 12b of the second converter 12 can be connected by one or more signal lines. Likewise, the second output 11c of the first converter 11, the reference port P4 and the second input 12c of the second converter 12 can be connected by one or more signal lines.

The first converter 11 and the second converter 12 can form an active directional element (ADE) of the active directional structure 10.

When the generator signal is fed to the generator port P1, the active directional element (i.e., the first and second converter 11, 12) can generate and forward the test signal to the DUT port P2 and the reference signal to the reference port P4. A DUT which is connected at the DUT port P2 can reflect an incident wave of the test signal. This reflected wave can be forwarded to the measurement port P3 via the second converter 12.

In the example shown in Fig. 1, the first converter is a power splitter.

The first converter 11 in Fig. 1 can convert the generator signal from single-ended to a differential signal pair (test signal and reference signal). The test signal and the reference signal, as outputted by the first respectively second output 11b, 11c, can be identical voltage signals Vi, in particular with identical sign (e.g., with the same polarity) and phase. Also, power splitter can generate the test signal and the reference signal with identical amplitude. In case their amplitude is difference, this difference is known.

The test signal Vi can be forwarded from the first output 11b to the DUT connected to the DUT port P2. A reflected signal Vr can be received at the DUT port P2 in response. This reflected signal Vr can be based on a reflection of the test signal Vi from the DUT (e.g., the DUT reflects a portion of the test signal Vi) . The first input 12b of the second converter 12 can receive the combined (e.g., superimposed) test signal and reflected signal (Vi + Vr).

The reference signal (here also Vi) can be forwarded from the second output 11c to the reference port P4 and to the second input 12c of the second converter 12. A reference impedance ZREF (e.g. 50Ω) can be connected to the reference port P4.

The second converter 12 can be an active subtraction element. For example, the second converter 12 is configured to calculate a difference between the reference signal (Vi) received at the second input 12c and the combined test signal and reflected signal (Vi + Vr) received at the first input 12b. In other words, the second converter 12 can be configured to subtract the reference signal (Vi) from the combined test and reflected signal (Vi + Vr). The measurement signal can be the result of this subtraction, namely: (Vi + Vr) - Vi = Vr.

The second converter 12 can be configured to output the measurement signal to the measurement port P3.

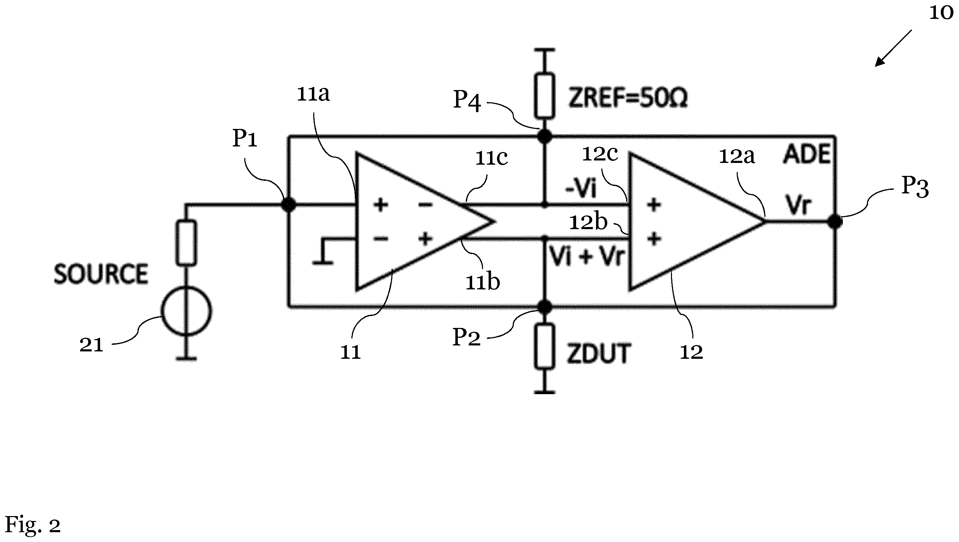

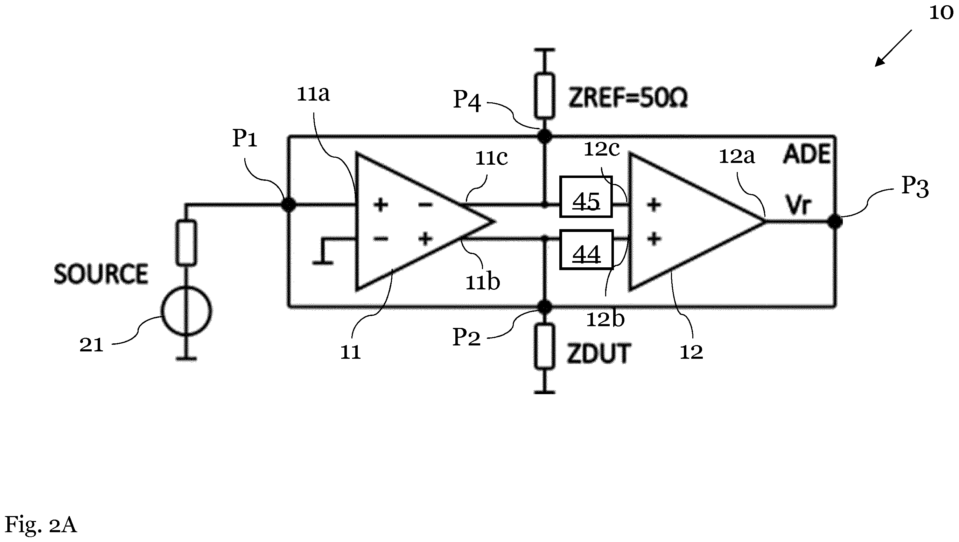

Fig. 2 shows an alternative implementation of the active directional element, wherein the first converter is a single-ended to differential converter and the second converter is a summation element. For example, the first converter in Fig. 2 is a single-ended to differential operational amplifier (opp amp).

The first converter 11 in Fig. 2 can convert the generator signal from single-ended to a differential signal pair. The test signal and the reference signal, as outputted by the first respectively second output 11b, 11c, can thus be inverted voltage signals Vi with identical amplitude and phase but opposite signs (e.g., signals with different polarity). For instance, the test signal is +Vi and the reference signal is -Vi.

The second converter 12 can be configured to calculate a sum between the reference signal (-Vi) received the second input 12c and the combined test signal and reflected signal (Vi + Vr) received at the first input 12b. The measurement signal can be the result of this sum, namely: (Vi + Vr) -Vi = Vr.

Fig. 2A shows a schematic diagram of the active directional structure 10 shown in Fig. 2, wherein a respective attenuator unit 44, 45 is directly connected in front of the first input 12b and the second input 12c of the second converter 12. In particular, the attenuator units 44, 45 are arranged before the DUT port P2 and the reference port P4 (as seen from the second converter 12).

Such attenuator units 44, 45 could also be added to the active directional structure 10 shown in Fig. 1. Furthermore, it is also possible to only add one of the attenuator units 44 and 45.

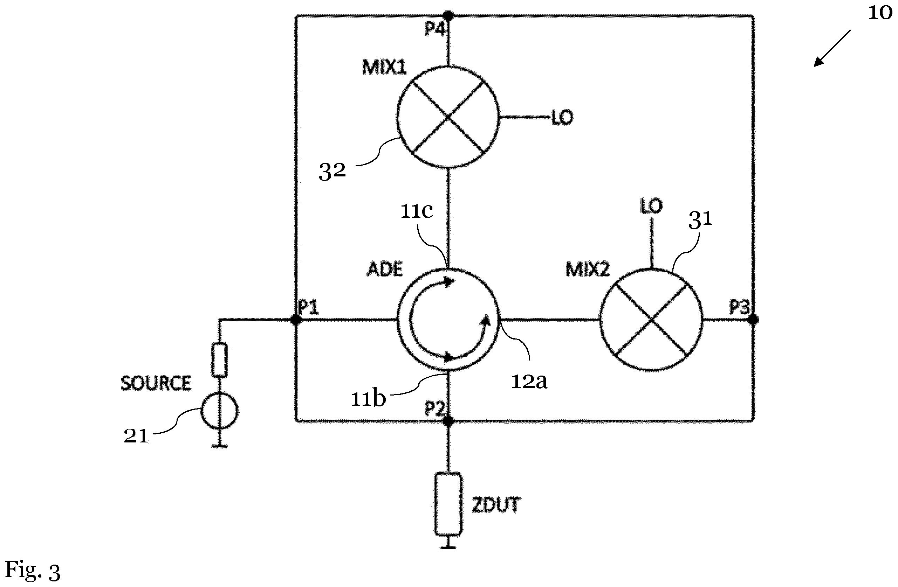

Fig. 3 shows a schematic diagram of the active directional structure 10 according to an embodiment. Thereby, the first and the second converter 11, 12 are represented by the active directional element ADE. The first and the second converter 11, 12 can be configured as shown in any one of Figs. 1 or 2.

The active directional structure 10 can comprise a first mixing device 31 which is connected between the output 12a of the second converter 12 and the measurement port P3, and/or a second mixing device 32 which is connected between the second output 11c of the first converter 11 and the reference port P4.

The first mixing device 31 and/or the second mixing device 32 can comprise a respective mixer which can be connected to a local oscillator LO.

The first mixing device 31 and the second mixing device 32 can be configured to down convert the measurement signal respectively the reference signal to an intermediate frequency. For instance, the mixing devices 31, 32 can down convert these signals to the base band.

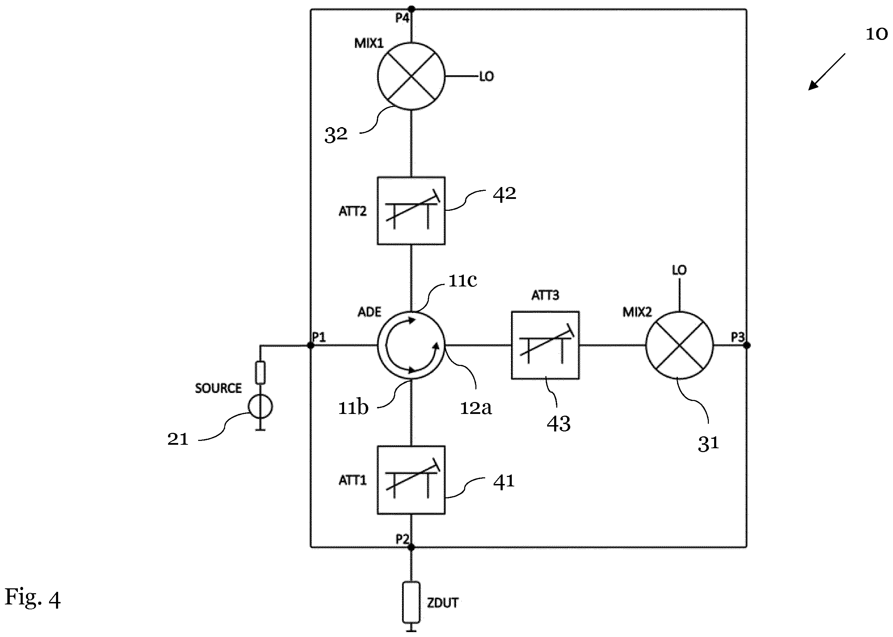

Fig. 4 shows a schematic diagram of the active directional structure 10 according to a further embodiment.

The active directional structure 10 in Fig.4 can be based on the structure 10 shown in Fig. 3, and comprises additional attenuator units 41, 42, 43.

For instance, a first attenuator unit 41 is arranged in a signal path between the first output 11b of the first converter 11 and the DUT port P2, a second attenuator unit 42 is arranged in a signal path between the second output 11c of the first converter 11 and the reference port P4, and a third attenuator unit 43 is arranged in a signal path between the output 12a of the second converter 12 and the measurement port P3.

Each of the attenuator units 41, 42, 43 can comprise a switchable attenuator block.

Depending on the requirements, the active directional structure 10 can comprise one, two or all of the first, second and third attenuator units 41, 42, 43. For example, an attenuator unit 41, 42, 43 is arranged before a mixer of a respective mixing device 31, 32.

The active directional structure 10 could also comprise any combination of the attenuator units 41, 42, 43 without the additional mixing devices 31, 32.

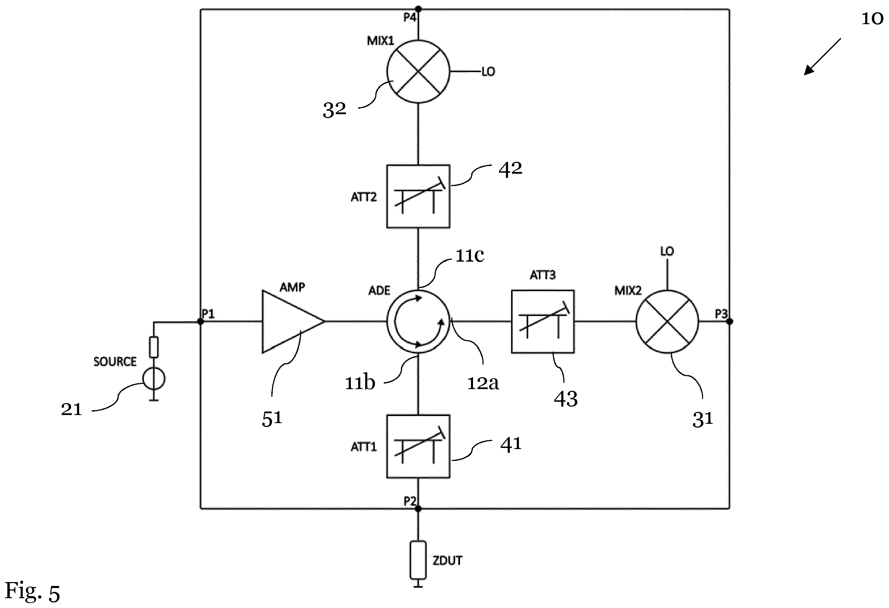

Fig. 5 shows a schematic diagram of the active directional structure 10 according to a further embodiment. The active directional structure 10 thereby comprises an additional amplifier unit 51 which is connected between the generator port P1 and the input 11a of the first converter 11.

The amplifier unit 51 can be configured to amplify the generator signal prior to feeding it to the input 11a of the first converter 11.

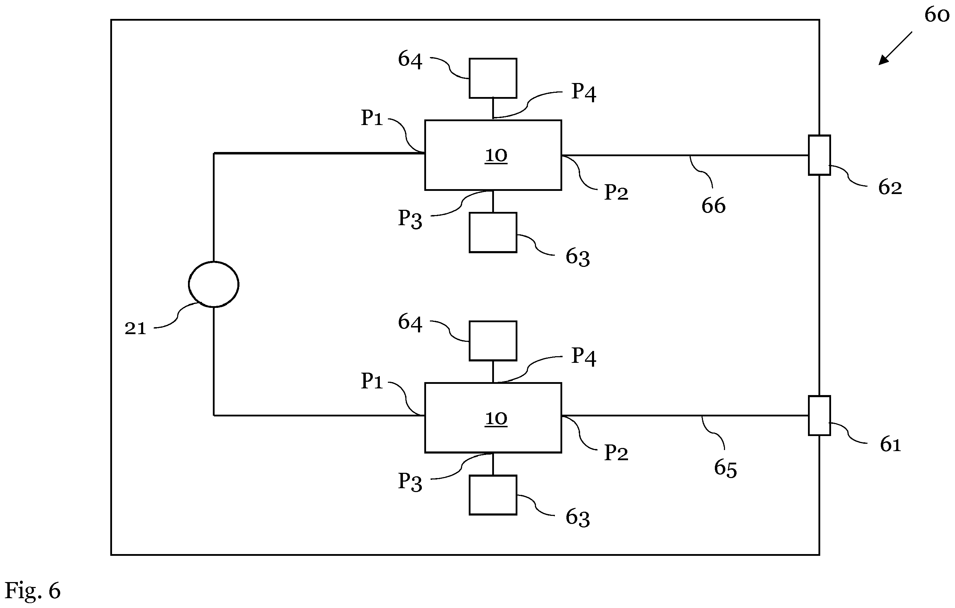

Fig. 6 shows a schematic diagram of a test and/or measurement system 60 according to an embodiment. For instance, the test and/or measurement system 60 can be a VNA.

The test and/or measurement system 60 comprises at least one active directional structure 10, as e.g. shown in any one of Figs. 1-5, and the signal generator 21 configured to generate the generator signal. The signal generator 21, in particular an output of the signal generator 21, is connected to the generator port P1 of the active directional structure 10.

As shown in Fig. 6, the test and/or measurement system 60 can comprise at least two active directional structures 10, wherein a generator port P1 of each structure 10 is connected to the signal generator 21, and a DUT port P2 of each structure 10 is connected to a respective VNA port 61, 62 via a respective measurement path 65, 66.

The DUT can be connected to the first and the second VNA port 61, 62.

Each of the active directional structures 10 can further comprise a first ADC unit 63 which is connected to the measurement port P3 and/or a second ADC unit 64 which is connected to the reference port P4.

The ADC units 63, 64 can be configured to digitalize the respective measurement signal and reference signal which is outputted by the ports P3, P4.

For example, additional elements, such as filters, can be arranged between the respective ADC units 63, 64 and the ports P3, P4.

The test and/or measurement system can comprise a processing unit which is communicatively connected to the measurement port P3 and the reference port P4. The processing unit can receive and further process the digitalized measurement and reference signals.

In this configuration, the VNA 60 can carry out network parameter, e.g. S-parameter, measurements with the DUT.

The active directional structure(s) 10 can be designed in the form of a monolithic (single) chip of the test and/or measurement system 60. For instance, all elements shown in Fig. 5 can be integrated in a chip, in particular the mixers 31, 32 and attenuator units 41-43.

The chip can comprise the active directional element (first and second converter), the optional mixing devices 31, 32 and the optional attenuator units 41-43. For example, the chip can be based on silicon germanium or other technologies. In this way, a size/footprint of the structure 10 and a PCB complexity of the system 60 can be drastically reduced. At the same time, performance parameters like bandwidth, directivity and temperature stability can be improved.

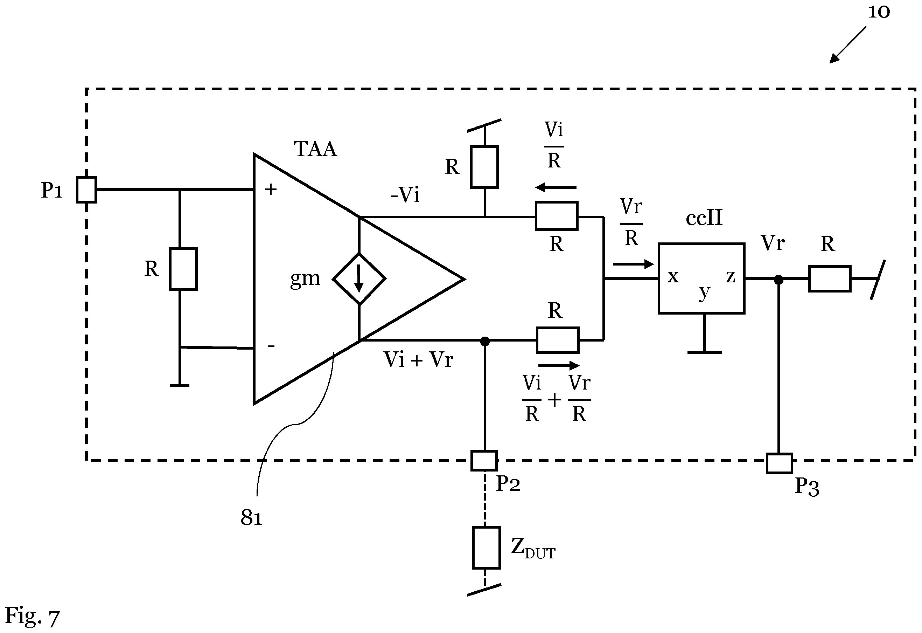

Fig. 7 shows a possible implementation of the active directional structure 10 according to an embodiment.

In the structure 10 shown in Fig. 7, the signal Vi received at the generator port P1 can be used to generate a differential current signal by means of a transadmittance amplifier (TAA) 81. The TAA 81 can form a differential current source (e.g., according to the first converter 11 in Fig. 2). For example, a differential transistor pair can be used as TAA 81.

One side of the differential current 81 source can be connected to the DUT port P2. In addition, a termination resistance R can also be connected to port P2. Thus, an impedance at port P2 can be R. Typically, R is 50 ohm.

Externally, a DUT with unknown impedance Zdut to be measured by the test and/or measurement system can be connected to the DUT port P2.

The other side of the differential current source 81 can also be connected to a termination resistance R, but instead of an unknown impedance Zdut, this side can additionally be loaded by a known and accurate reference resistance R.

Instead of connecting the other end of the termination resistors to ground (or to a constant supply voltage), a means to measure the sum of the currents through the two termination resistors can be used (e.g., according to the second converter 12 in Fig. 2) .

As shown in Fig. 7, the active directional structure 10 can comprise an ideal type II current conveyor (ccII) as such means.

The function of this idealized element is to force the voltage applied to terminal Y onto terminal X. In addition, the current flowing into terminal X is transferred to high-impedance output terminal Z. In particular, a ccII can be implemented by a single transistor or an op-amp feedback circuit.

Assuming that Zdut is exactly 50 ohm, the differential current can make a voltage signal Vi appear on port P2 and a voltage signal -Vi (same magnitude but opposite polarity) on the reference resistor on the opposite side of the bridge. The currents flowing through the termination resistors can both have a magnitude of Vi / R, but flow in opposite directions. The sum of the two currents, which flows through the ccII to port P3, is therefore zero.

In the case where Zdut is not exactly 50 ohm, a reflected voltage Vr will appear on port P2 in addition to Vi. In this case, the sum of the currents through the two termination resistors is Vr / R, which causes the voltage at port P3 to be the reflected voltage Vr. This allows measuring the reflected voltage Vr at the measurement port P3.

The structure 10 can be fully symmetrical, except that one side of the bridge is loaded by Zdut, whereas the other side is loaded by R. In an integrated circuit implementation, excellent matching can be achieved between the two sides, which can translate to excellent directivity.

Instead of directly measuring the sum of the two termination resistor currents, it is also possible to measure the current through each resistor separately and add the two currents later on.

The active directional structure 10 as shown in any one of Figs. 1-7 can be designed as a small, wideband directional circuit for network analyzer ports. The structure 10 can be fully integrated on a monolithic chip.

Compared to circulator designs based on a balun (active or passive), the active directional structure 10 has the advantage that the entire signal power generated by the circuit can be transmitted to the DUT. This can mitigate the need for additional (off-chip) passive components attenuating the signal.

Compared to possible op-amp based active circulator implementations, the active directional structure 10 can operate very fast since it may comprise only few transistors operating in a feedforward configuration.

The active directional structure 10 can further achieve a very high directivity, because it can be based on a matching between two signal paths identical in structure (see, e.g., Figs. 1-2 and 7).

Besides its above discussed use in VNAs, the structure 10 could also be used for separating a transmit path from a receive path in wireless communication or radar devices in which a common antenna is used by both paths.

## Claims

1. An active directional structure (10) for a test and/or measurement system (60), comprising:
a generator port (P1) configured to receive a generator signal;
a DUT port (P2) arranged for directly or indirectly connecting a device-under-test, DUT;
a measurement port (P3) configured to output a measurement signal;
a reference port (P4) configured to output a reference signal;
a first converter (11) which is configured to:
- receive the generator signal at an input (11a) which is connected to the generator port (P1),
- generate a test signal based on the generator signal and output the test signal at a first output (11b) which is connected to the DUT port (P2), and
- generate the reference signal based on the generator signal and output the reference signal at a second output (11c) which is connected to the reference port (P4); and
a second converter (12) which is configured to:
- receive the test signal and a reflected signal from the DUT at a first input (12b),
- receive the reference signal at a second input (12c), and
- generate the measurement signal based on the test signal, the reflected signal and the reference signal and output the measurement signal at an output (12a) which is connected to the measurement port (P3);
wherein the first converter (11) and/or the second converter (12) comprise a respective transistor circuit.

2. The active directional structure (10) of claim 1,
wherein the first converter (11) is a power splitter.

3. The active directional structure (10) of claim 2,
wherein the second converter (12) is configured to calculate a difference between the combined test signal and reflected signal received at the first input (12b) and the reference signal received at the second input (12c), and to output the measurement signal based on said difference.

4. The active directional structure (10) of claim 1,
wherein the first converter (11) is a single-ended to differential converter.

5. The active directional structure (10) of claim 4,
wherein the second converter (12) is configured to calculate a sum of the combined test signal and the reflected signal received at the first input (12b) and the reference signal received at the second input (12c), and to output the measurement signal based on said sum.

6. The active directional structure (10) of any one of the preceding claims, further comprising:
a first mixing device (31) which is connected between the output (12a) of the second converter (12) and the measurement port (P3).

7. The active directional structure (10) of any one of the preceding claims, further comprising:
a second mixing device (32) which is connected between the second output (11c) of the first converter (11) and the reference port (P4).

8. The active directional structure (10) of any one of the preceding claims, further comprising:
a first attenuator (41) unit which is connected between the first output (11b) of the first converter (11) and the DUT port (P2); and/or
a second attenuator unit (42) which is connected between the second output (11c) of the first converter (11) and the reference port (P4); and/or
a third attenuator unit (43) which is connected between the output (12a) of the second converter (12) and the measurement port (P3).

9. The active directional structure (10) of any one of the preceding claims, further comprising:
a fourth attenuator unit (44) which is connected directly in front of the first input (12b) of the second converter (12); and/or
a fifth attenuator unit (45) which is connected directly in front of the second input (12c) of the second converter (12).

10. The active directional structure (10) of any one of the preceding claims, further comprising:
an amplifier unit (51) which is connected between the generator port (P1) and the input (11a) of the first converter (11) .

11. The active directional structure (10) of any one of the preceding claims,
wherein the active directional structure is a part of a chip.

12. A test and/or measurement system (60), comprising:
at least one active directional structure (10) according to any of the preceding claims;
a signal generator (21) configured to generate the generator signal, wherein an output of the signal generator (21) is connected to the generator port (P1) of the active directional structure (10).

13. The test and/or measurement system (60) of claim 12,
wherein the test and/or measurement (60) system is a vector network analyzer.

14. The test and/or measurement system (60) of claim 12 or 13, further comprising:
a first ADC unit (63) which is connected to the measurement port (P3).

15. The test and/or measurement system of any one of claims 12 to 14, further comprising:
a second ADC unit (64) which is connected to the reference port (P4).
